(19) Europäisches Patentamt
European Patent Office
Office européen des brevets

(11) **EP 2 998 710 B1**

(12) **EUROPÄISCHE PATENTSCHRIFT**

(45) Veröffentlichungstag und Bekanntmachung des Hinweises auf die Patenterteilung:
**10.01.2018 Patentblatt 2018/02**

(51) Int Cl.:
**G01B 21/16** (2006.01)     **G05B 15/02** (2006.01)
**H03M 1/26** (2006.01)     **H04Q 9/00** (2006.01)
**G01D 21/00** (2006.01)

(21) Anmeldenummer: **15002899.1**

(22) Anmeldetag: **03.11.2011**

(54) **VERFAHREN UND VORRICHTUNG ZUR ZYKLISCHEN DIGITALEN ÜBERTRAGUNG EINES POSITIONSWERTES EINES BEWEGTEN OBJEKTES MIT TRÄGER MASSE**

METHOD AND DEVICE FOR THE CYCLICAL DIGITAL TRANSMISSION OF A POSITION VALUE OF A MOVING OBJECT WITH INERTIAL MASS

PROCEDE ET DISPOSITIF DE TRANSMISSION NUMERIQUE CYCLIQUE D'UNE VALEUR DE POSITION D'UN OBJET EN MOUVEMENT A L'AIDE D'UNE MASSE INERTE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.12.2010 DE 102010054141**
**31.05.2011 DE 102011103735**

(43) Veröffentlichungstag der Anmeldung:
**23.03.2016 Patentblatt 2016/12**

(62) Dokumentnummer(n) der früheren Anmeldung(en) nach Art. 76 EPÜ:
**11785584.1 / 2 649 416**

(73) Patentinhaber: **Sew-Eurodrive GmbH & Co. KG**
**76646 Bruchsal (DE)**

(72) Erfinder: **Simon, Olaf**
**D-76646 Bruchsal (DE)**

(56) Entgegenhaltungen:
**EP-A2- 2 023 092     DE-B3-102007 062 333**

EP 2 998 710 B1

**Beschreibung**

Die Erfindung betrifft ein Verfahren und Vorrichtung zur zyklischen digitalen Übertragung eines Positionswertes eines bewegten Objektes mit träger Masse.

Winkelsensoren sind allgemein bekannt. Bei Winkelsensoren, die als Inkrementalgeber ausgeführt sind, wird der erfasste Winkelwert einer Welle digital übertragen.

Aus der DE 10 2007 062 333 B3 ist als nächstliegender Stand der Technik ein Verfahren und Vorrichtung zur zyklischen digitalen Übertragung eines Positionswertes eines bewegten Objektes mit träger Masse bekannt.

Aus der EP 2 023 092 A2 ist ein Positionsmessgerät und ein Verfahren zur Übertragung einer Bewegungsinformation bekannt.

Der Erfindung liegt daher die Aufgabe zugrunde, die Übertragung der erfassten Werte vom Winkelsensor an ein elektronisches Gerät weiterzubilden, wobei eine schnelle Vorausbestimmung der Position ermöglicht werden soll.

Erfindungsgemäß wird die Aufgabe bei dem Verfahren zur Regelung eines Antriebs nach den in Anspruch 1 angegebenen Merkmalen gelöst.

Wichtige Merkmale bei dem Verfahren zur Regelung eines Antriebs sind, dass zeitlich wiederkehrend ein Positionswert erfasst wird und die zugehörige Information an eine Regelvorrichtung übertragen wird, insbesondere mit einem Verfahren nach mindestens einem der vorangegangenen Ansprüche,

wobei der Positionswert gekennzeichnet ist durch zumindest zwei Werte, insbesondere Teilwinkelwert und Feinwinkelwert, insbesondere digitale Werte,

wobei der erste Wert mit einer ganzen Zahl kennzeichenbar ist und jeder Zahl ein Positionswertebereich zugeordnet ist,

wobei jedem durch einen ersten Wert gekennzeichneten Positionsbereich zueinander separate Teilbereiche des Positionsbereichs zugeordnet sind, wobei jeder dieser Teilbereiche durch einen zweiten Wert gekennzeichnet ist, der als ganze Zahl kennzeichenbar ist,

wobei der zweite Wert zeitlich vor dem ersten Wert übertragen wird,

wobei

(i) nach Übertragen des neu erfassten zweiten Wertes aus dem neu erfassten und dem zuvor übertragenen zweiten Wert ein erster Wert bestimmt wird, welcher dem neu erfassten ersten Wert entspricht, und der so bestimmte Positionswert von einer Regeleinrichtung verwendet wird, um einen aktualisierten Wert einer Stellgröße der Regeleinrichtung zu bestimmen,

insbesondere wobei der Schritt (i) wiederholt wird.

Von Vorteil ist dabei, dass die Zeitdauer der Übertragung des ersten Wertes schon nutzbar ist zur Bestimmung des nächsten Stellgrößenwertes.

Wichtige Merkmale bei dem Verfahren zur Regelung eines Antriebs sind, dass zeitlich wiederkehrend ein Positionswert erfasst wird und die zugehörige Information an eine Regelvorrichtung übertragen wird,

wobei der Positionswert gekennzeichnet ist durch zumindest zwei Werte, insbesondere Teilwinkelwert und Feinwinkelwert, insbesondere digitale Werte,

wobei der erste Wert mit einer ganzen Zahl kennzeichenbar ist und jeder Zahl ein Positionswertebereich zugeordnet ist,

wobei jedem durch einen ersten Wert gekennzeichneten Positionsbereich zueinander separate Teilbereiche des Positionsbereichs zugeordnet sind, wobei jeder dieser Teilbereiche durch einen zweiten Wert gekennzeichnet ist, der als ganze Zahl kennzeichenbar ist,

wobei der zweite Wert zeitlich vor dem ersten Wert übertragen wird,

wobei

(i) nach Übertragen des neu erfassten zweiten Wertes aus dem neu erfassten und dem zuvor übertragenen zweiten Wert unter zusätzlicher Berücksichtigung der zuletzt bestimmten Geschwindigkeit, ein erster Wert bestimmt wird, welcher dem neu erfassten ersten Wert entspricht, und der so bestimmte Positionswert von einer Regeleinrichtung verwendet wird, um einen aktualisierten Wert einer Stellgröße der Regeleinrichtung zu bestimmen,

(ii) wobei nach Übertragung des neu erfassten zweiten Wertes aus dem neu erfassten ersten Wert und neu erfassten zweiten Wert der Geschwindigkeitswert aktualisiert wird, wobei auch der zuvor erfasste erst Wert und der zuvor erfasste zweite Wert berücksichtigt wird,

wobei die Schritte (i) und (ii) wiederholt werden. Von Vorteil ist dabei, dass auch bei einer auftretenden Geschwindigkeit ein Schätzwert bestimmbar ist und dieser nur noch korrigiert werden muss.

Bei einer vorteilhaften Ausgestaltung wird nach Übertragen des ersten Wertes dieser verglichen mit dem gemäß Schritt (i) bestimmten Wert und bei Abweichung eine Aktion ausgelöst wird, insbesondere wie Anzeigen und/oder Übermitteln einer Warninformation und/oder Abschalten des Antriebs und/oder Auslösen eines Sicheren Zustandes des Antriebs. Von Vorteil ist dabei, dass die Sicherheit erhöht ist.

Bei einer vorteilhaften Ausgestaltung wird in einem Sensor ein Positionswert erfasst und der Sensor ist über eine digitale Schnittstelle mit einer Auswerteeinheit verbunden,

wobei die Auswerteeinheit einen Speicher aufweist und Mittel zur Bestimmung des Positionswertes aus einem übertragenen wertebereichsbeschränkten Positionswert aufweist,

insbesondere wobei die Auswerteeinheit mit einer Regeleinrichtung verbunden ist.

Von Vorteil ist dabei, dass nur eine geringe Bandbreite bei der Datenübertragung notwendig ist.

Wichtige Merkmale der Erfindung bei dem Verfahren zur zyklischen digitalen Übertragung eines Positionswertes eines bewegten Objektes mit träger Masse sind, dass der Wertebereich des übertragenen Positionswertes derart eingeschränkt ist, dass sich keine vollständige Umdrehung oder im Fall einer linearen Bewegung andere durch mechanische Gegebenheiten bedingte vollständige Periode abbilden lässt und die tatsächliche Position durch Erkennen von Wertebereichsüberschreitungen in einer Auswerteeinheit gebildet wird, insbesondere

- wobei zu einem ersten Zeitpunkt eine nicht oder eine weit weniger stark wertebereichsbeschränkte Position als im kontinuierlichen Betrieb übertragen wird

- und/oder wobei der Wertebereich dadurch bestimmt wird, dass die in einem Abtastzyklus auftretende Wegdifferenz bei maximaler Geschwindigkeit kleiner als die Hälfte des gewählten Wertebereichs ist, wobei der Wertebereich möglichst klein gewählt wird

und/oder wobei anstelle der wertebereichsbeschränkenden Absolutposition die Differenz zur vorherigen Position mit gleicher Wertebereichsbeschränkung übertragen wird.

Von Vorteil ist dabei, dass die digitale Übertragung robust ist gegen Störeinwirkungen, wie beispielsweise Magnetfeldeinstrahlungen oder dergleichen.

Wichtige Merkmale bei dem Verfahren zur zyklischen digitalen Übertragung eines Positionswertes eines bewegten Objektes mit träger Masse, sind, dass der Wertebereich des übertragenen Positionswertes derart eingeschränkt ist, dass sich keine vollständige Umdrehung oder im Fall einer linearen Bewegung andere durch mechanische Gegebenheiten bedingte vollständige Periode abbilden lässt und die tatsächliche Position durch Erkennen von Wertebereichsüberschreitungen in einer Auswerteeinheit gebildet wird, insbesondere

- wobei zu einem ersten Zeitpunkt eine nicht oder eine weit weniger stark wertebereichsbeschränkte Position als im kontinuierlichen Betrieb übertragen wird

- und/oder wobei der Wertebereich dadurch bestimmt wird, dass die in einem Abtastzyklus auftretende Wegdifferenz bei maximaler Geschwindigkeit kleiner als die Hälfte des gewählten Wertebereichs ist, wobei der Wertebereich möglichst klein gewählt wird

- und/oder wobei anstelle der wertebereichsbeschränkenden Absolutposition die Differenz zur vorherigen Position mit gleicher Wertebereichsbeschränkung übertragen wird.

Von Vorteil ist dabei, dass ein nur geringer Datenstrom übertragen werden muss und somit eine geringe Bandbreite ausreicht für die Übertragung. Außerdem ist eine erhöhte Sicherheit realisierbar, da nach Übertragen des vollständigen Positionswertes ein Vergleich mit dem aus dem wertebereichseingeschränkten Wert bestimmten Positionswert ausführbar ist und somit überwachbar ist, ob die maximal erlaubte Beschleunigung überschritten wurde, also ein unvorhergesehenes Ereignis, wie Fehler oder dergleichen, aufgetreten ist. Alternativ ist auch das zyklische Übertragen des vollständigen Positionswerts verzichtbar, wodurch somit eine Datenverbindung mit geringer Bandbreite ausreicht für eine schnelle Positionswertübertragung. Die von einem Sensor erfassten Daten sind also komprimierbar und datenkomprimiert übertragbar.

Durch den Vergleich der Differenz mit dem halben Wertebereich ist eine Rekonstruktion der vollständigen Information über den Positionswert in einfacher Weise ausführbar.

Wichtige Merkmale bei dem alternativen Verfahren zur zyklischen digitalen Übertragung eines Positionswertes eines bewegten Objektes mit träger Masse nach Anspruch 2 sind, dass der Wertebereich des übertragenen Positionswertes gegenüber dem Wertebereich möglicher Positionswerte eingeschränkt ist, insbesondere so dass sich keine vollständige Umdrehung oder im Fall einer linearen Bewegung andere durch mechanische Gegebenheiten bedingte vollständige Periode abbilden lässt,

und die tatsächliche Position dadurch bestimmt wird, dass aus der vorherigen Position und der vorherig bestimmten Geschwindigkeit ein Schätzwert für die Position gebildet wird und diese mittels des wertebereichsbeschränkten übertragenen Positionswertes korrigiert wird, insbesondere

- wobei durch einen Vergleich des wertebereichsbeschränkten Positionsschätzwertes mit dem wertebereichsbeschränkten übertragenen Positionswert eine Wertebereichsüberschreitung ermittelt und zur Korrektur des Schätzwertes herangezogen wird,

- und/oder wobei einmalig am Anfang eine Position übertragen wird, deren Werteberiech den Bereich möglicher auftretender Positionen umfasst

- und/oder wobei anstatt der wertebereichsbeschränkten Absolutposition die Differenz zur vorherigen Position mit gleicher Wertebereichsbeschränkung übertragen wird.

Von Vorteil ist dabei, dass der Positionswert an einer trägen Masse erfasst wird. Durch die daher ermöglichte Begrenzung der auftretenden Beschleunigungen und Rucke, also zeitlichen Ableitungen der Beschleunigungen, ist ermöglicht, dass die Geschwindigkeitsänderung in der zugehörigen Zykluszeit begrenzt ist und somit ein Schätzwert nur korrigiert werden muss um weniger als eine Auflösungseinheit, beispielsweise einer grob aufgelösten Spur.

Wichtige Merkmale bei dem Verfahren zur digitalen Übertragung eines Positionswertes eines bewegten Objektes mit träger Masse nach Anspruch 3 sind, dass der Positionswert gekennzeichnet ist durch zumindest zwei Werte, insbesondere Teilwinkelwert und Subwinkelwert und/oder Feinwinkelwert, insbesondere digitale Werte,

wobei der erste Wert mit einer ganzen Zahl kennzeichenbar ist und jeder Zahl ein Positionswertebereich zugeordnet ist,

wobei jedem durch einen ersten Wert gekennzeichneten Positionsbereich zueinander separate Teilbereiche des Positionsbereichs zugeordnet sind, wobei jeder dieser Teilbereiche durch einen zweiten Wert gekennzeichnet ist, der als ganze Zahl kennzeichenbar ist,

wobei zu einem ersten Zeitpunkt ein Positionswert erfasst wird und der zugehörige erste und zweite Wert übertragen wird,

wobei

(i) ein weiterer Positionswert erfasst wird und der zugehörige, somit neu erfasste, zweite Wert übertragen wird,

(ii) worauf aus dem neu erfassten, zweiten Wert und dem zuvor erfassten, zweiten Wert der durch den ersten Wert gekennzeichnete Positionswertebereich bestimmt wird, also somit auch der zum neu erfassten Positionswert zugehörige erste Wert.

Von Vorteil ist dabei, dass wiederum zu einem ersten Zeitpunkt die vollständige Information über den erfassten Positionswert vorliegt und somit ein daraufhin nur relativ zu diesem ersten Positionswert bestimmter neuer Positionswert bestimmt wird. Somit ist eine komprimierte Datenübertragung ermöglicht oder eine erhöhte Redundanz bei der Datenübertragung.

Bei einer vorteilhaften Ausgestaltung weist der Positionswert einen Winkelwert eines drehenden Teiles, also Objektes, wobei das Objekt als träge Masse ein Trägheitsmoment auf. Von Vorteil ist dabei, dass die volle Umdrehung von 360° in mehrere Teilbereiche aufteilbar ist und somit eine Auflösung der vollen Umdrehung in die so entstandenen Positionswertebereiche ermöglicht ist.

Bei einer vorteilhaften Ausgestaltung wird die Übertragung zeitlich wiederkehrend wiederholt, insbesondere also zyklisch wiederholt wird, insbesondere in regelmäßigen Zeitabständen,

insbesondere wobei Schritt (i) und (ii) mehrfach nacheinander ausgeführt werden. Von Vorteil ist dabei, dass ständig wiederkehrend die Position bestimmbar ist. Dabei sind die Zeitabstände vorzugsweise derart kurz, dass wiederum die maximal zu erwartende Positionswertänderung unterhalb eines kritischen Wertes verbleibt, der vorzugsweise einen halben Positionswertebereich unterschreitet.

Bei einer vorteilhaften Ausgestaltung wird bei Schritt (ii) aus dem zuvor erfassten oder bestimmten Positionswert und der zugehörigen Geschwindigkeit ein Schätzwert bestimmt und der zweite Wert des neu erfassten Positionswertes mit dem zweiten Wert des Schätzwertes verglichen und die Differenz zwischen dem zweiten Wert des neu erfassten Positionswertes und dem zweiten Wert des Schätzwertes bestimmt und daraus der zum neu erfassten Positionswert zugehörige Positionsbereich bestimmt. Von Vorteil ist dabei, dass ein Geschwindigkeitswert bekannt ist und daher ein Schätzwert überhaupt bestimmbar ist, indem zum alten Positionswert die aus der Geschwindigkeit und dem zugehörigen Zeitintervall sich ergebende Positionswerteänderung addiert wird.

Bei einer vorteilhaften Ausgestaltung wird bei Schritt (ii) die Differenz zwischen neu erfasstem zweiten Wert und zuvor erfasstem zweiten Wert bestimmt, insbesondere wobei bei Überschreiten eines halben Positionsbereichs darauf geschlossen wird, dass der neu erfasste Positionswert in einem benachbarten Positionsbereich liegt. Von Vorteil ist dabei, dass in einfacher Weise aus der bloßen Differenz und dem Wissen über die maximal zu erwartende Änderung des Positionswertes der neue Positionswert vollständig bestimmbar ist, obwohl nur ein eingeschränkter Wertebereich übertragen werden muss.

Bei einer vorteilhaften Ausgestaltung wird bei Schritt (ii) ein Vergleich zwischen neu erfasstem zweiten Wert und zuvor erfasstem zweiten Wert bestimmt und derjenige benachbarte Bereich bestimmt, in welchem der neu erfasste Positionswert sich befindet, insbesondere wenn die Differenz zwischen neu erfasstem zweiten Wert und zuvor erfasstem zweiten Wert einen halben Positionsbereich überschreitet. Von Vorteil ist dabei, dass in einfacher Weise ein vollständiges Bestimmen des Positionswertes trotz der übertragenen und eingeschränkten Information ermöglicht ist.

Bei einer vorteilhaften Ausgestaltung ist die Änderung der Geschwindigkeit zwischen zwei in einem Zeitabstand $\Delta t$ nacheinander ausgeführten Positionserfassungen auf einen kritischen Wert begrenzt, insbesondere welcher durch die träge Masse bestimmt oder zumindest mitbestimmt ist. Von Vorteil ist dabei, dass nur eine endliche Anzahl, insbesondere Zwei, von möglichen Positionswerten erreichbar ist und nur aus dieser endlichen Anzahl der neue Positionswert bestimmt werden muss.

Bei einer vorteilhaften Ausgestaltung ist der Positionswert ein Winkelwert oder eine Linearposition, insbesondere wobei die Geschwindigkeit eine Winkelgeschwindigkeit oder eine in Linearrichtung auftretende Geschwindigkeit ist. Von Vorteil ist dabei, dass die Erfindung bei rotatorischen und linearen Antriebsregelungen verwendbar ist, also unabhängig von der Sorte des Positionserfassenden Sensors.

Bei einer vorteilhaften Ausgestaltung sind ein erster und zweiter Wert einer jeweiligen Spur, insbesondere Geberspur, zugeordnet, wobei der erste Wert einer feiner auflösenden Spur als der zweite Wert zugeordnet ist. Von Vorteil ist dabei, dass nur ein eingeschränkter Informationswert übertragen werden muss und trotzdem die vollständige Information über die Position erhältlich ist.

Bei einer vorteilhaften Ausgestaltung sind jedem durch einen zweiten Wert, insbesondere Subwinkelwert, gekennzeichneten Positionsbereich zueinander separate Teilbereiche des Positionsbereichs zugeordnet, wobei jeder dieser Teilbereiche durch einen dritten Wert, insbesondere Feinwinkelwert, gekennzeichnet ist, der als ganze Zahl kennzeichenbar ist,

insbesondere wobei zu dem ersten Zeitpunkt der Positionswert erfasst wird und der zugehörige erste und zweite und dritte Wert übertragen wird,

wobei der dritte mit dem zweiten Wert übertragen wird, insbesondere vor oder nach dem zweiten Wert. Von Vorteil ist dabei, dass als erster Wert ein Teilwinkel und als zweiter Wert ein Subwinkel erfassbar und übertragbar sind, wobei der Subwinkel durch ein Feinwinkelbereich noch feiner auflösbar ist. Dabei genügt dann die Übertragung der Feinwinkel und Subwinkelinformation, um den grober auflösenden Teilwinkel zu bestimmen.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

Bei dem erfindungsgemäßen Antriebssystem ist ein Winkelsensor mit einer Welle des Antriebs, beispielsweise Motorwelle eines umrichtergespeisten Elektromotors oder mit einer Welle eines von einem umrichtergespeisten Elektromotor angetriebenen Getriebes, drehfest verbunden, so dass die Winkelstellung erfassbar ist.

Hierbei wird in einem ersten Zeitabschnitt der Winkelwert in digitaler Form, also als digitales Telegramm oder Wort, übertragen.

Der an die Signalelektronik des Umrichters übertragene Wert wird von einer in der Signalelektronik vorgesehenen Regeleinheit verwendet, um den Motorstrom durch Stellen der Motorspannung auf einen jeweiligen gewünschten Sollwert hin zu regeln.

Der Winkelwert wird dabei gekennzeichnet durch einen Teilwinkelbereich und zumindest noch einen Feinwinkelbereich. Dabei ist der Teilwinkel nur eine grobe Auflösung der gesamten Umdrehung von 360°. Der Feinwinkel unterteilt den jeweiligen Teilwinkelbereich in feinere Winkelabschnitte.

Bei der Übertragung des Winkelwertes wird zeitlich zuerst der Feinwinkelwert übertragen und danach der gröbere Teilwinkelwert.

Durch Berücksichtigung von kritischen Werten, insbesondere maximalen Beschleunigungswerten und/oder maximalen Rucken, also zeitlichen Ableitungen der Beschleunigung, und unter Berücksichtigung des zuletzt bekannten Winkelwerts und Winkelgeschwindigkeitswerts ist es für die Signalelektronik ermöglicht, schon aus den Feinwinkelwerten den neu erfassten winkelwert zu bestimmen.

Auf diese Weise ist es der Regeleinheit ermöglicht, besonders früh den neu erfassten Winkelwert für die Regelung zu berücksichtigen. Zur erfindungsgemäßen Bestimmung des neu erfassten Winkelwertes sind nur wenige Rechenschritte notwendig, weshalb nur wenig Rechenzeit aufgewendet werden muss. In der Regeleinheit wird dann aus dem so bestimmten Winkelwert und weiteren Werten der jeweils neu vom Umrichter zu stellende Motorspannungswert berechnet.

Während dieser Berechnungszeit werden dann auch die gröberen Teilwinkelwerte vom Winkelsensor an die Signalelektronik des Umrichters übertragen.

Somit ist dann rechtzeitig vor dem nächsten Zeitschritt der wirkliche erfasste Winkelwert direkt bekannt. Somit ist dann die Sicherheit erhöht, da der aus dem Feinwinkel bestimmte und der in Gänze übertragene Winkelwert miteinander verglichen werden kann. Außerdem ist für die nächste Winkelbestimmung aus dem nächsten Feinwinkelwert unter Verwendung des ganz übertragenen Winkelwerts und eines entsprechend aktualisierten Winkelgeschwindigkeitswerts ausführbar.

Somit wird - mit anderen Worten - also in jedem Zeitschritt der zuletzt vollständig, umfassend also Feinwinkelwert und Teilwinkelwert, übertragene Wert verwendet und unter Differenzbildung zum vorherigen Wert die aktualisierte Geschwindigkeit bestimmt. Aus diesen Werten wird dann ein Schätzwert bestimmt für den nächsten zu erwartenden Winkelwert. Zur Bestimmung dieses Winkelwertes wird berücksichtigt, dass der Antrieb eine träge Masse, insbesondere linear oder rotatorisch, antreibt und dabei die Geschwindigkeit im zugehörigen Zeitschritt nur um einen maximalen Betrag sich ändern kann. Dieser so bestimmte Schätzwert ist auch durch einen Feinwinkelwert, einen Teilwinkelwert und gegebenenfalls einen Subwinkelwert kennzeichenbar. Der dann neu übertragene Feinwinkelwert des neu erfassten und vom Winkelsensor übertragenen Winkelwerts wird dann verwendet zur Bestimmung des neuen Winkelwerts, welcher dann sofort von der Regeleinheit verwendet wird. Nach der parallel hierzu erfolgten vollständigen Übertragung des neu erfassten Winkelwerts wird dann ein Vergleich ausgeführt mit dem nur aus dem übertragenen Feinwinkelwert bestimmten Wert, wodurch eine Sicherheitsgerichtete Überprüfung ausführbar ist. Das Verfahren wird wiederholt, wobei aus dem vollständig übertragenen Winkelwert wiederum die aktualisierte Winkelgeschwindigkeit bestimmt wird und dann entsprechend wiederholend verwendet wird.

In einer Ausführungsvariante wird der vollständig übertragene Winkelwert nur zu einem ersten Zeitschritt verwendet. In den nachfolgenden Zeitschritten wird dann mehrfach nur der aus dem jeweiligen Schätzwert und dem Feinwinkelwert, vorzugsweise auch aus einem zusätzlichen Subwinkelwert, bestimmte Winkelwert verwendet.

Zur weiteren Verbesserung ist ein Subwinkelbereich vorgesehen, dessen Auflösung zwischen der Auflösung des Feinwinkelbereichs und des Teilwinkelbereichs vorgesehen ist.

In einer ersten Ausführungsvariante werden zwei Spuren vorgesehen, nämlich die Teilwinkelspur und die Feinwinkelspur. Dabei sind in Umfangsrichtung m Teilwinkelberieche angeordnet und die Teilwinkelbereiche in Umfangsrichtung gleich lang. Ebenso sind die Feinwinkelbereiche in Umfangsrichtung gleich lang. Jedem Teilwinkelabschnitt sind die gleiche Anzahl von Feinwinkelbereichen zugeordnet, wobei diese Anzahl jeweils von 0 bis n - 1 durchzählbar ist. Dabei ist m und n jeweils ganzzahlig.

Nach einem ersten Zeitabschnitt, in welchem der Teilwinkelwert, also die Nummer des Teilwinkels vom Winkelsensor erfasst wird, und der Feinwinkelwert F1, also die Nummer des Feinwinkels vom Winkelsensor erfasst wird, wird nach einem Zeitabstand $\Delta t$ der Feinwinkelwert F2 erfasst.

Zur Bestimmung des Winkelwertes, also der fehlenden Information über den neuen Teilwinkelwert, wird aus der Differenz des neuen zum vorherigen Feinwinkelwert F2 - F1 und aus dem Vergleich von F1 und F2 bestimmt, ob ein Überlauf in positiver oder negativer Umdrehungsrichtung stattgefunden hat oder nicht. Hierzu ist wichtig, dass die mögliche maximale Winkelgeschwindigkeit v_max nur derart klein ist, dass gilt

$$- \ (½ * m - 1) \leq v\_max * \Delta t \leq (½ * m ),$$

Somit ist bei Überlauf nur der Eintritt in einen nächstbenachbarten Teilwinkel, also Teilwinkelbereich, möglich. Wenn also die Winkelerfassung in sehr kleinem Zeitabstand $\Delta t$ ausgeführt wird, ist eine eindeutige Rekonstruktion des neu erfassten Winkelwertes aus der bloßen Information des neu erfassten Feinwinkelmesswertes und des vorigen Winkelwertes ermöglicht.

Diese Erfassung des Feinwinkelwertes ist nach einem jeweiligen weiteren Zeitabstand $\Delta t$ beliebig oft wiederholbar. Somit genügt sogar die Übertragung des Feinwinkelwertes allein, um den jeweils neu erfassten Winkelwert zu bestimmen, wobei allerdings zu einem ersten Zeitpunkt der erfasste Winkelwert vollständig bekannt sein muss.

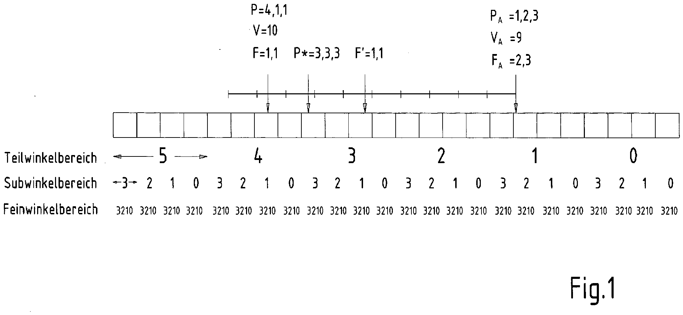

In der Figur 1 ist eine zweite Ausführungsvariante mit drei Spuren erläutert, nämlich mit einer Teilwinkelspur, einer Subwinkelspur und einer Feinwinkelspur, welche die Subwinkelspur feiner auflöst. Dabei sind in Umfangsrichtung m Teilwinkelberieche angeordnet, beispielsweise m = 32, und die Teilwinkelbereiche in Umfangsrichtung gleich lang. Ebenso sind die Subwinkelbereiche in Umfangsrichtung jeweils gleich lang, wobei jeder Teilwinkel in n Subwinkelbereiche aufgeteilt ist. Die Feinwinkelbereiche sind in Umfangsrichtung jeweils gleich lang, wobei jedem Subwinkelbereich q Feinwinkelbereiche zugeordnet sind. Jedem Teilwinkelabschnitt sind die gleiche Anzahl von Subwinkelbereichen zugeordnet, wobei diese Anzahl jeweils von 0 bis n -1 durchzählbar ist. Dabei ist m, q und n jeweils ganzzahlig. In Figur 1 ist q = 4 und n = 4.

Da die Winkelerfassung an einem System mit träger Masse ausgeführt wird und die auftretenden Beschleunigungen unterhalb eines Maximalwertes a_max liegen, ist eine Änderung der Winkelgeschwindigkeit innerhalb des Zeitabstandes $\Delta t$ nur um die maximale Geschwindigkeitsdifferenz

$$\Delta v\_max = \ a\_max * \Delta t$$

möglich.

Aus der zuletzt bekannten Winkelgeschwindigkeit v_alt und dem zuletzt bekannt Winkel $\alpha$_alt ergibt sich ein Schätzwert

$$\alpha\_Sch\ddot{a}tz = \ \alpha\_alt + v\_alt \ * \Delta t$$

Die Winkeländerung zu diesem Schätzwert beträgt maximal $\Delta v$_max $* \Delta t$ und erzeugt einen maximalen Überlauf des Subwinkels in den nächstbenachbarten Subwinkelbereich.

Daher muss zur Bestimmung des nächsten winkelwertes nicht der erfasste neue Wert des Teilwinkels, Subwinkels und Feinwinkels vorliegen sondern es genügen der Subwinkel und der Feinwinkel, wenn der für den vorigen Zeitabschnitt gültige Winkelwert bekannt ist. Denn aus dem Vergleich des alten Subwinkelwertes mit dem neuen Subwinkelwert und aus der Differenz zwischen neuem und alten Subwinkelwert ergibt sich der neue Subwinkelbereich. Da der neue Feinwinkel übermittelt ist, ist auch dieser Wert bekannt, wobei der Feinwinkelwert dem neuen Subwinkelwert eineindeutig einen Winkelwert zuordnet.

Dieses Verfahren ist in Figur 1 an einem konkreten Beispiel darstellbar: Der alte Winkelwert ist beispielhaft $P_A$ = (Teilwinkelwert = 1, Subwinkelwert = 2 , Feinwinkelwert = 3). Dabei beträgt die alte Winkelgeschwindigkeit 9 Subwinkelbereiche pro Zeitabschnitt $\Delta t$.

Somit ergibt sich ein Schätzwert von P*= (Teilwinkelwert = 3, Subwinkelwert = 3, Feinwinkelwert = 3).

Wenn nun der neue Messwert den Feinwinkel 1 und Subwinkel 1 aufweist, ergeben sich zwei mögliche Winkelwerte, die als F = (Subwinkel 1, Feinwinkel 1) und F' = (Subwinkel 1, Feinwinkel 1) bezeichnet sind. Da nun aber die maximal auftretende Geschwindigkeitsänderung $\Delta v\_max = a\_max * \Delta t$ wiederum derart gewählt ist, dass $Av\_max * \Delta t$ kleiner als der halbe Teilwinkelbereich ist, wird durch die Differenzbildung und den Vergleich klar feststellbar, dass der neue Winkelwert F ist, aber nicht F'. Der neue Winkelwert wird somit bestimmt als P= (Teilwinkelwert = 4, Subwinkelwert = 1, Feinwinkelwert =1), woraus die neue Geschwindigkeit als 10 Subwinkelbereiche pro Zeitabschnitt $\Delta t$ bestimmt wird. Eine Übertragung des neu erfassten Teilwinkelwertes ist also einsparbar.

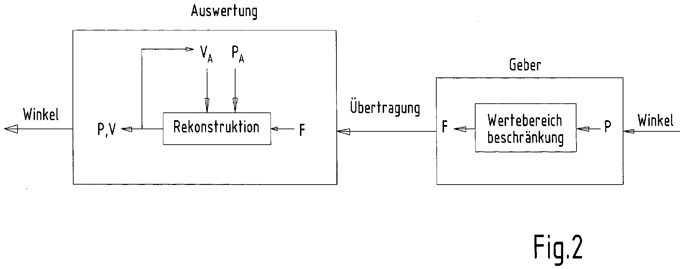

In Figur 2 ist das Verfahren näher dargestellt. Dabei wird zunächst die neu erfasste Information über den Winkelwert P im Winkelsensor reduziert auf eine Teilinformation F, welche nur den Subwinkelwert und den Feinwinkelwert, nicht aber den Teilwinkelwert enthält. Dieser Wert F wird übertragen an die Auswerteschaltung, welche vorzugsweise in der Steuerelektronik eines Wechselrichters oder Umrichters angeordnet ist.

In der Auswerteschaltung wird aus der Teilinformation F unter Berücksichtigung des zuvor erfassten oder bestimmten Winkelwertes $P_A$ und der zuvor bestimmten Winkelgeschwindigkeit $v_A$ der neu erfasste Winkelwert P und die neu auftretende Winkelgeschwindigkeit v bestimmt.

## Bezugszeichenliste

$P_A$ zuvor erfasster Winkelwert
P* Schätzwert für Winkel
P neu bestimmter Winkelwert
F Zwischenwert
F' zweiter Zwischenwert
$v_A$ zuvor bestimmte Winkelgeschwindigkeit

## Patentansprüche

1.   Verfahren zur Regelung eines Antriebs,
wobei zeitlich wiederkehrend jeweils ein Positionswert erfasst wird und die zugehörige Information an eine Regelvorrichtung übertragen wird,
wobei der jeweilige Positionswert **gekennzeichnet ist durch** jeweils zumindest zwei Werte, insbesondere Teilwinkelwert und Feinwinkelwert, insbesondere digitale Werte,
wobei der jeweilige erste Wert mit einer ganzen Zahl kennzeichenbar ist und jeder Zahl ein Positionswertebereich zugeordnet ist, wobei jedem durch einen ersten Wert gekennzeichneten Positionswertebereich zueinander separate Teilbereiche des Positionswertebereichs zugeordnet sind, wobei jeder dieser Teilbereiche durch einen zweiten Wert gekennzeichnet ist, der als ganze Zahl kennzeichenbar ist, wobei der zweite Wert zeitlich vor dem ersten Wert übertragen wird,

**dadurch gekennzeichnet, dass**

(i) nach Übertragen des neu erfassten zweiten Wertes aus dem neu erfassten und dem zuvor übertragenen zweiten Wert unter zusätzlicher Berücksichtigung der zuletzt bestimmten Geschwindigkeit und dem zugehörigen Zeitintervall ein erster Wert bestimmt wird, welcher dem neu erfassten ersten Wert entspricht, und der so bestimmte Positionswert von einer Regeleinrichtung verwendet wird, um einen aktualisierten Wert einer Stellgröße der Regeleinrichtung zu bestimmen, (ii) wobei nach Übertragung des neu erfassten zweiten Wertes aus dem neu erfassten ersten Wert und neu erfassten zweiten Wert der Geschwindigkeitswert unter Berücksichtigung des zugehörigen Zeitintervalls aktualisiert wird, wobei auch der zuvor erfasste erste Wert und der zuvor erfasste zweite Wert berücksichtigt wird,

wobei die Schritte (i) und (ii) wiederholt werden.

2.   Verfahren nach Anspruch 1,
**dadurch gekennzeichnet, dass**
nach Übertragen des ersten Wertes dieser verglichen wird mit dem gemäß Schritt (i) bestimmten Wert und bei Abweichung eine Aktion ausgelöst wird, insbesondere wie Anzeigen und/oder Übermitteln einer Warninformation und/oder Abschalten des Antriebs und/oder Auslösen eines Sicheren Zustandes des Antriebs.

3.   Vorrichtung, mit einer Regelvorrichtung, die zur Regelung eines Antriebs ausgelegt ist, wobei die Vorrichtung so ausgebildet ist ein Verfahren nach Anspruch 1 oder 2 auszuführen, und mit einem Mittel zur zeitlich wiederkehrenden Erfassung von Positionswerten und einem Mittel zur Übertragung zugehöriger Information an eine Regelvorrichtung, wobei in einem Sensor ein Positionswert erfasst wird und der Sensor über eine digitale Schnittstelle mit einer Auswerteeinheit verbunden ist,
wobei die Auswerteeinheit einen Speicher aufweist und Mittel zur Bestimmung des Positionswertes aus einem übertragenen wertebereichsbeschränkten Positionswert aufweist, insbesondere wobei die Auswerteeinheit mit einer Regeleinrichtung verbunden ist.

## Claims

1.   A method for controlling a drive,
wherein periodically in each case a position value is detected and the associated information is transmitted to a control device,
wherein the respective position value is **character-**

**ised by** at least two values in each case, in particular partial angle value and fine angle value, in particular digital values,

wherein the respective first value is able to be characterised with a whole number and a range of position values is associated with each number,

wherein partial ranges of the range of position values which are separate from each other are associated with each range of position values which is **characterised by** a first value, each of these partial ranges being **characterised by** a second value which can be characterised as a whole number,

wherein the second value is transmitted timewise before the first value,

**characterised in that**

(i) after transmission of the newly detected second value, a first value being determined from the newly detected and the previously transmitted second value while additionally taking into account the last-determined speed and the associated time interval, which first value corresponds to the newly detected first value, and the position value thus determined being used by a control means in order to determine an updated value of a controlled variable of the control means,

(ii) with after transmission of the newly detected second value the speed value being updated from the newly detected first value and newly detected second value, taking into account the associated time interval, with the previously detected first value and the previously detected second value also being taken into account.

with steps (i) and (ii) being repeated.

2. A method according to Claim 1,
**characterised in that**
after transmission of the first value this is compared with the value determined in accordance with step (i), and in the event of deviation an action is triggered, in particular such as displaying and/or communicating warning information and/or switching off the drive and/or triggering a safe state of the drive.

3. A device, with a control device which is designed for controlling a drive,
wherein the device is formed so as to carry out a method according to Claim 1 or 2, and with a means for periodically detecting position values and a means for transmitting associated information to a control device,
wherein in a sensor a position value is detected and the sensor is connected via a digital interface to an evaluation unit,
wherein the evaluation unit has a memory and has means for determining the position value from a transmitted value-range-restricted position value, in particular wherein the evaluation unit is connected to a control means.

**Revendications**

1. Procédé de régulation d'une unité d'entraînement, dans lequel une valeur de position est détectée de façon récurrente dans le temps et l'information correspondante est transmise à un dispositif de régulation,
dans lequel la valeur de position respective est **caractérisée par** chaque fois au moins deux valeurs, en particulier une valeur d'angle partiel et une valeur d'angle fin, en particulier des valeurs numériques,
dans lequel la première valeur respective peut être **caractérisée par** un nombre entier et une plage de valeurs de position est associée à chaque nombre,
dans lequel à chaque plage de valeurs de position **caractérisée par** une première valeur sont associées des plages partielles séparées entre elles de la plage de valeurs de position, chacune de ces plages partielles étant **caractérisée par** une deuxième valeur qui peut être **caractérisée** comme un nombre entier,
dans lequel la deuxième valeur est transmise avant la première valeur dans le temps, **caractérisé en ce que**

(i) après transmission de la deuxième valeur nouvellement détectée, une première valeur, qui correspond à la première valeur nouvellement détectée, est déterminée à partir de la deuxième valeur nouvellement détectée et de la deuxième valeur précédemment transmise en tenant compte en plus de la vitesse déterminée en dernier lieu et de l'intervalle de temps associé, et la valeur de position ainsi déterminée est utilisée par un dispositif de régulation pour déterminer une valeur actualisée d'une grandeur réglante du dispositif de régulation,
(ii) dans lequel, après transmission de la deuxième valeur nouvellement détectée, la valeur de vitesse est actualisée à partir de la première valeur nouvellement détectée et de la deuxième valeur nouvellement détectée en tenant compte de l'intervalle de temps associé, la première valeur précédemment détectée et la deuxième valeur précédemment détectée étant également prises en compte,

dans lequel les étapes (i) et (ii) sont répétées.

2. Procédé selon la revendication 1, **caractérisé en ce qu'**après transmission de la première valeur, celle-ci est comparée avec la valeur déterminée selon l'étape (i) et, en cas d'écart, une action est déclenchée, en particulier comme l'affichage et/ou la transmission d'une information d'avertissement et/ou l'arrêt de l'unité d'entraînement et/ou le déclenchement d'un état sûr de l'unité d'entraînement.

3. Dispositif comprenant un dispositif de régulation qui est réalisé pour réguler une unité d'entraînement, lequel dispositif est réalisé pour mettre en oeuvre un procédé selon la revendication 1 ou 2, et comprenant un moyen de détection récurrente dans le temps de valeurs de position et un moyen de transmission de l'information correspondante à un dispositif de régulation,
dans lequel une valeur de position est détectée dans un capteur et le capteur est relié à une unité d'évaluation par l'intermédiaire d'une interface numérique,
dans lequel l'unité d'évaluation présente une mémoire et des moyens pour déterminer la valeur de position à partir d'une valeur de position transmise, limitée dans sa plage de valeurs, en particulier dans lequel l'unité d'évaluation est reliée à un dispositif de régulation.

Fig.1

Auswertung

Geber

$V_A$  $P_A$

Winkel

P,V  Rekonstruktion  F  Übertragung  F  Wertebereich beschränkung  P  Winkel

Fig.2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007062333 B3
- EP 2023092 A2